(19) **Europäisches Patentamt / European Patent Office / Office européen des brevets**

(11) **EP 4 768 932 A1**

(12) **EUROPEAN PATENT APPLICATION**
published in accordance with Art. 153(4) EPC

(43) Date of publication:
**01.07.2026 Bulletin 2026/27**

(21) Application number: 25827283.0

(22) Date of filing: **12.05.2025**

(51) International Patent Classification (IPC):
*G01R 31/36* (2020.01)   *G01R 31/367* (2019.01)
*G01R 31/385* (2019.01)   *G01R 31/396* (2019.01)

(52) Cooperative Patent Classification (CPC):
G01R 31/36; G01R 31/367; G01R 31/385;
G01R 31/396

(86) International application number:
**PCT/KR2025/006405**

(87) International publication number:
**WO 2026/005274 (02.01.2026 Gazette 2026/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **26.06.2024 KR 20240083788**

(71) Applicants:
• **LG Energy Solution, Ltd.**
  **Seoul 07335 (KR)**
• **Seoul National University R&DB Foundation**
  **Seoul 08826 (KR)**

(72) Inventors:
• **LEE, Bora**
  **Daejeon 34122 (KR)**
• **LEE, Jong Min**
  **Seoul 08826 (KR)**
• **JUNG, Eunjoo**
  **Daejeon 34122 (KR)**
• **KIM, Haechang**
  **Seoul 08826 (KR)**
• **YUN, Ji Young**
  **Seoul 08826 (KR)**
• **KIM, Hyeongseok**
  **Daejeon 34122 (KR)**

(74) Representative: **Plasseraud IP**
  **104 Rue de Richelieu**
  **CS92104**
  **75080 Paris Cedex 02 (FR)**

(54) **ELECTRONIC DEVICE AND METHOD FOR ANALYZING BATTERY PERFORMANCE INFLUENCING FACTOR THEREOF**

(57)    Provided is a method for analyzing a battery performance influencing factor of an electronic device, the method comprising the steps of: identifying a causal graph indicating a relationship between a plurality of factors related to a battery manufacturing process and process data including, as each data instance, data on the plurality of factors identified for each execution of the battery manufacturing process; and identifying influence information on the characteristics of a final product for each of the plurality of factors on the basis of the causal graph, the process data, and a model trained to predict the characteristics of the final product of the battery manufacturing process by receiving the process data.

FIG. 2

```
                    ┌───────┐
                    │ Start │
                    └───┬───┘
                        │
┌───────────────────────────────────────────────────┐
│ Identify causality graph showing relationship      │
│ between plurality of factors associated with       │ ~ S210
│ battery manufacturing process and process data     │
│ that includes data on plurality of factors, which  │
│ is identified for each time of performing battery  │
│ manufacturing process, as individual data instance │
└───────────────────────┬───────────────────────────┘
                        │
┌───────────────────────────────────────────────────┐
│ Identify information on impact on final product    │
│ property for each of plurality of factors based    │ ~ S220
│ on causality graph, process data, and model        │
│ trained to predict final product property in       │
│ battery manufacturing process by receiving         │
│ process data as input                              │
└───────────────────────┬───────────────────────────┘
                        │
                    ┌───┴───┐
                    │  End  │
                    └───────┘
```

EP 4 768 932 A1

## Description

### Technical Field

The present disclosure relates to an electronic device and a battery performance affecting factor analysis method thereof.

### Background Art

In a battery manufacturing process, various sensors and process factors are related in a complex nonlinear manner, so that identifying parameters that affect the process is difficult. In this regard, although studies to determine factors that mainly affect battery cell performance have been conducted by using machine learning and explainable artificial intelligence (XAI) algorithms, such related arts have difficulties in that the interpretation has been conducted under an assumption that independence is present between unit processes in the whole process. Specifically, such a method that assumes the independence between the unit processes does not reflect the characteristics of the battery manufacturing process in which the unit processes for several mechanisms are sequentially connected, and provides an interpretation that is far from an actual system behavior.

When such a wrong analysis method is used as a base, major factors among numerous factors forming the battery process are incorrectly selected, and thus efficient quality management and product design becomes difficult. Therefore, the accuracy of determining major factor contribution may be required to be increased by searching for a data-based analysis method that may reflect the causal relationship between such process factors and measured values.

### Detailed Description of the Invention

### Technical Goals

Example embodiments of the present disclosure are to provide an electronic device and a battery performance affecting factor analysis method thereof. Specifically, example embodiments of the present disclosure are to provide a data-based analysis method that may reflect a causal relationship between process factors and measured values in order to increase accuracy of determining major factor contribution.

However, the goals to be achieved by example embodiments of the present disclosure are not limited to the objectives described above and other objects may be clearly understood from the following example embodiments.

### Technical solutions

According to an aspect, there is provided a battery performance affecting factor analysis method of an electronic device, the battery performance affecting factor analysis method including identifying a causality graph showing a relationship between a plurality of factors associated with a battery manufacturing process and process data that includes data on the plurality of factors, which is identified for each time of performing the battery manufacturing process, as an individual data instance, and identifying information on an impact on a final product property for each of the plurality of factors based on the causality graph, the process data, and a model trained to predict the final product property in the battery manufacturing process by receiving the process data as an input, and the causality graph shows materiality nodes that are connected in a one-way direction corresponding to an order of detailed processes included in the battery manufacturing process and individually correspond to an intermediate product feature and the final product property which are generated individually in the detailed processes, and a plurality of process parameter nodes that is connected to each of the materiality nodes in one-way directions and corresponds to process parameters controlled in each of the detailed processes which individually correspond to the materiality nodes.

The battery performance affecting factor analysis method may further include identifying, based on the causality graph, a plurality of paths connected from the plurality of process parameter nodes to a materiality node corresponding to the final product property, identifying a virtual data instance by adjusting at least a portion of data of the data instance included in the process data based on the plurality of identified paths, inputting the virtual data instance to the model, and identifying the information on the impact by analyzing an output, of the model, on the virtual data instance.

The identifying of the virtual data instance may include identifying, based on the plurality of paths, at least one first path including an edge between a first node corresponding to a first factor and a second node corresponding to a child node of the first node in the causality graph, and identifying at least one first virtual data instance based on the at least one first path, and the identifying of the information on the impact may include identifying first value information on the first path based on the first virtual data instance and the model, and identifying an impact value of the first factor on a second factor corresponding to the second node based on the first value information.

The identifying of the at least one first virtual data instance may include identifying at least one path positioned before the at least one first path in a plurality of permutations in which the plurality of paths is randomly arranged, identifying, for each of the plurality of permutations, a first subset including the at least one path positioned before the at least one first path and a second subset including the first path in addition to the first subset, and identifying a first-first virtual data instance by sampling randomly and adjusting data on a node not corresponding to the first subset in the data of the data instance and identifying a first-second virtual data instance by sampling randomly and adjusting data on a node not corresponding to the second subset in the data of the data instance, and the identifying of the first value information may include identifying first-first value information and first-second value information based on a result of inputting, to the model, the first-first virtual data instance and the first-second virtual data instance which are identified for each of the plurality of permutations, and identifying the first value information based on information on a difference between the first-first value information and the first-second value information.

The identifying of the first value information may include identifying the first value information on the first path based on information on an average of pieces of information on the difference between the first-first value information and the first-second value information identified for each of the plurality of mutations.

The identifying of the first value information may include identifying first-first output information by inputting the first-first virtual data instance to the model, and identifying the first-first value information based on information on a difference between the first-first output information and information on an average of pieces of output information identified by inputting the data instance is not adjusted.

The identifying of the information on the impact of the first factor may include identifying a first impact value of the first factor on the second factor based on information on a sum of pieces of the first value information on the first path which includes the edge between the first node and the second node.

The identifying of the information on the effect may include identifying a matrix that includes an impact value, of a first factor corresponding to a first coordinate on a first axis, on a second factor corresponding to a second coordinate on a second axis, as an element, and identifying, based on the matrix, the information on the impact which includes information on a direct impact and information on an indirect impact, of the plurality of factors, on the final product property.

The identifying of the information on the impact may include identifying an impact value of at least one factor corresponding to at least one node directly connected to a node corresponding to the final product property in the matrix, and identifying the information on the direct impact based on the impact value of the at least one factor.

The identifying of the impact value of the at least one factor may include identifying a coordinate corresponding to the final product property on the second axis, identifying a vector in the matrix, which has the coordinate corresponding to the final product property on the second axis and is parallel to the first axis, and identifying the impact value of the at least one factor based on the vector.

The identifying of the information on the effect may include identifying, by factor corresponding to each of the process parameter nodes, information on a sum of impact values, and identifying, by factor corresponding to each of the process parameter nodes, the information on the indirect impact based on the information on the sum.

The identifying of the information on the sum may include identifying a coordinate corresponding to each of the process parameters on the first axis, identifying each of vectors in the matrix, which has the coordinate corresponding to each of the process parameters on the first axis and is parallel to the second axis, and identifying, by factor corresponding to each of the process parameter nodes, information on a sum of impact values included in each of the vectors.

The battery performance affecting factor analysis may further include identifying, based on the information on the impact, contribution ratio information showing ratios of values of the information on the direct impact and the information on the indirect impact for each of the plurality of factors.

The battery performance affecting factor analysis method may further include supporting control of the intermediate product feature based on the information on the direct impact.

The battery performance affecting factor analysis method may further include supporting control of the process parameters for each of the detailed processes based on the information on the indirect impact.

The identifying of the causality graph and the process data may include identifying whole process data identified for each time of performing the battery manufacturing process, calculating a coefficient of correlation between whole factors of the battery manufacturing process based on the whole process data, identifying the plurality of factors by filtering at least a portion of factors of which the coefficient of correlation is greater than or equal to a threshold value among the whole factors, and identifying at least a portion of data, which corresponds to the plurality of factors in the whole process data, as the process data.

The identifying of the at least a portion of data, which corresponds to the plurality of factors in the whole process data, as the process data may include identifying a data instance, in which a measured temperature of the final product property corresponds to a valid temperature range among data instances included in the whole process data, as the process data.

The battery performance affecting factor analysis method may further include inputting the process data to the model in units of the data instance, and training the model based on a result of comparison between actual data corresponding to the final product property identified in units of the data instance and an output of the model.

According to another aspect, there is also provided an electronic device for analyzing a battery performance affecting factor, the electronic device including a processor, and a memory configured to store one or more instructions, and the processors is configured to, by executing the one or more instructions, identify a causality graph showing a relationship between a plurality of factors associated with a battery manufacturing process and process data that includes data on the plurality of factors, which is identified for each time of performing the battery manufacturing process, as an individual data instance, and identify information on an impact on a final product property for each of the plurality of factors based on the causality graph, the process data, and a model trained to predict the final product property in the battery manufacturing process by receiving the process data as an input, and the causality graph shows materiality nodes that are connected in a one-way direction corresponding to an order of detailed processes included in the battery manufacturing process and individually correspond to an intermediate product feature and the final product property which are generated individually in the detailed processes, and a plurality of process parameter nodes that is connected to each of the materiality nodes in one-way directions and corresponds to process parameters controlled in each of the detailed processes which individually correspond to the materiality nodes.

According to still another aspect, there is also provided a non-transitory computer-readable recording medium in which a program for executing the above-described battery performance affecting factor analysis method on a computer is recorded.

Additional aspects of example embodiments will be set forth in part in the description which follows and, in part, will be apparent from the description.

**Effects of the Invention**

According to proposed example embodiments, one or more of the following effects may be expected.

According to the example embodiments, it is possible to increase accuracy of determining major factor contribution through a data-based analysis method that may reflect a causal relationship between process factors and measured values.

According to the example embodiments, it is possible to interpret an impact of a process factor by classifying as a direct impact or an indirect impact depending on an objective.

Effects of the present disclosure are not limited to those described above and other effects may be made apparent to those skilled in the art from the following description of the accompanying claims.

**Brief Description of Drawings**

FIG. 1 is a diagram illustrating an example of operation of an electronic device that analyzes a battery performance affecting factor according to an example embodiment.

FIG. 2 is a flowchart for describing a battery performance affecting factor analysis method according to an example embodiment.

FIG. 3 is an example diagram illustrating a causality graph according to an example embodiment.

FIG. 4 is an example diagram illustrating a path connected from a process parameter node to a materiality node corresponding to a final product property in a causality graph according to an example embodiment.

FIG. 5 is a diagram illustrating an example of a matrix including an impact value according to an example embodiment.

FIG. 6 is a diagram illustrating an example of identifying information on a direct impact by using a matrix according to an example embodiment.

FIG. 7 is a diagram illustrating an example of identifying information on an indirect impact by using a matrix according to an example embodiment.

FIGS. 8A and 8B are graphs showing information on a direct impact and information on an indirect impact according to an example embodiment.

FIG. 9 is an example diagram illustrating contribution ratio information according to an example embodiment.

FIG. 10 is a block diagram illustrating an electronic device according to an example embodiment.

**Mode for Carrying Out the Invention**

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element.

Throughout the specification, expression "at least one of a, b, and c" may include 'a only', 'b only', 'c only', 'a and b', 'a and c', 'b and c', or 'all of a, b, and c'.

In the present disclosure, a "terminal" may be implemented as a computer or a portable terminal capable of accessing a server or another apparatus through a network. The computer may include, for example, a laptop computer, a desktop computer, and a notebook equipped with a web browser. The portable apparatus may be a wireless communication device ensuring a portability and a mobility, and include any type of handheld wireless communication device, for example, a tablet PC, a smartphone, a communication-based apparatus such as international mobile telecommunication (IMT), code division multiple access (CDMA), W-code division multiple access (W-CDMA), and long term evolution (LTE).

In the following description, example embodiments of the present disclosure will be described in detail with reference to the accompanying drawings so that those skilled in the art can easily carry out the present disclosure. However, the present disclosure may be embodied in many different forms and is not limited to the example embodiments described herein.

Hereinafter, the example embodiments of the present disclosure will be described with reference to the accompanying drawings.

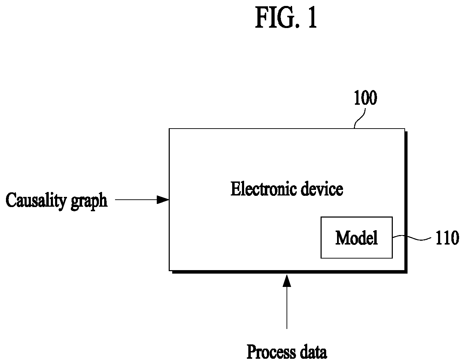

FIG. 1 is a diagram illustrating an example of operation of an electronic device that analyzes a battery performance affecting factor according to an example embodiment.

Referring to FIG. 1, an electronic device 100 may operate by receiving a causality graph and process data as inputs, which will be described below. In addition, the electronic device 100 may include a model 110.

Here, the model 110 may be implemented by using a machine-learning algorithm that may reflect a nonlinear correlation between process factors, for example, various algorithms such as XGBoost, Random Forest, or a deep neural network (DNN), but is not limited to the above-description. The model 110 may be a model trained to output a final product property (FPP) generated by a whole battery manufacturing process by receiving data corresponding to a factor corresponding to a process parameter (PP) controlled in each detailed process of the battery manufacturing process and receiving data corresponding to an intermediate product feature (IPF) generated in each detailed process. A training method therefor may be determined in association with a model construction scheme based on the above-described various algorithms or another algorithm.

Meanwhile, elements exclusively associated with the present example embodiment are illustrated in FIG. 1. Thus, those skilled in the art associated with the present example embodiment may understand that other elements in general use in addition to the elements illustrated in FIG. 1 may be further included.

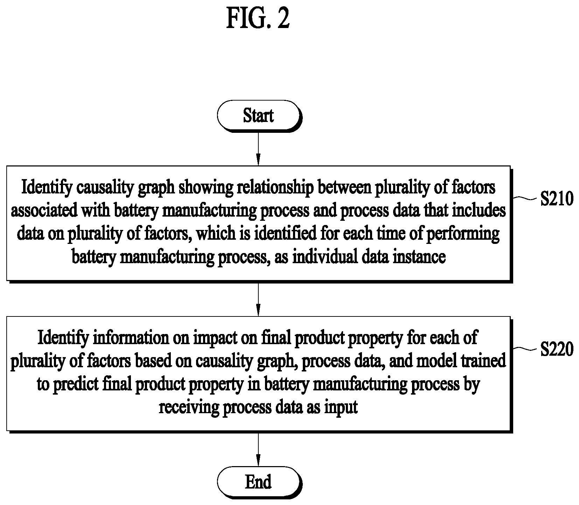

FIG. 2 is a flowchart for describing a battery performance affecting factor analysis method according to an example embodiment.

In operation S210, the electronic device 100 may identify a causality graph showing a relationship between a plurality of factors associated with a battery manufacturing process and process data that includes data on the plurality of factors, which is identified for each time of performing the battery manufacturing process, as an individual data instance. In operation S220, the electronic device 100 may identify information on an impact on a final product property for each of the plurality of factors based on the causality graph, the process data, and the model 110 trained to predict the final product property in the battery manufacturing process by receiving the process data as an input. Hereinafter, the battery performance affecting factor analysis method according to an example embodiment of the present disclosure will be described in detail.

To begin with, the electronic device 100 may acquire the causality graph. According to an example embodiment, the causality graph may be acquired by an input, to the electronic device 100, by a user that has domain knowledge associated with the battery manufacturing process, an input sent from another server to the electronic device 100, or analysis, by the electronic device 100, of process factors associated with the battery manufacturing process.

Such a causality graph may include materiality nodes, which are connected in a one-way direction corresponding to an order of detailed processes included in the battery manufacturing process and individually correspond to an intermediate product feature and the final product property which are generated individually in the detailed processes, and a plurality of process parameter nodes, which is connected to each of the materiality nodes in one-way directions and corresponds to process parameters controlled in each of the detailed processes which individually correspond to the materiality nodes. As inferable from the above description, the causality graph may be a type of a directed acyclic graph (DAG).

Here, an example of each of the detailed process included in the battery manufacturing process may include a mixing process, a coating process, a roll pressing process, a slitting and notching process, an assembling process, an activation process, an aging process, a degassing process, or the like, but is not limited to the above-described process, and also is not required to include all the above-described processes. In addition, an example of a process parameter may include slurry temperature, slurry flow amount, a pump, coating gap length, drying temperature and air volume, coating speed, coating thickness, and coating loading for the coating process, rolling roll gap length, rolling pressure, rolling speed, and rolling thickness for a rolling process, lamination plate temperature, lamination force, lamination roller temperature, lamination speed and dimension, and the like for the assembling process, and J/F temperature and pressure, aging time, inter-process waiting time, electrolyte amount, performance measurement temperature, final cell thickness, and the like for the activation process, a post-process, and a whole process. Similarly, the example of the process parameter is not limited to the above description and not required to include all the above-described examples. Also, an example of the intermediate product feature may include a rolling rate, loading after rolling, negative electrode thickness after activation, loading amount of one mono-cell, amount of air gaps in positive electrodes and negative electrodes after coating, rolling, and activation, or the like. An example of the final product property may include discharging capacity, discharging capacity fitted to a measured temperature, charging resistance, or the like. However, examples of the intermediate product feature and the final product property are not limited to the above-description and not required to include all the above-described examples.

According to an example embodiment, a portion of whole factors associated with the battery manufacturing process may be selected, so that the battery performance affecting factor analysis method of the present disclosure may be performed. As an example, the electronic device 100 may identify whole process data identified for each time of performing the battery manufacturing process. Then, the electronic device 100 may calculate a coefficient of correlation between the whole factors of the battery manufacturing process based on the whole process data. The electronic device 100 may identify the plurality of factors by filtering at least a portion of factors of which the coefficient of correlation greater is than or equal to a threshold value among the whole factors. In other words, a representative factor among the factors between which the coefficient of correlation is greater than or equal to the threshold value may exclusively remain, and others may be filtered. As an example, when a combination has factors A, B, C, and D between which coefficients of correlation are greater than or equal to the threshold value, one factor therein (e.g., a factor A) may exclusively remain, and other factors may be filtered. Here, according to an example embodiment, a factor that remains without being filtered may have highest permutation importance in a group of the factors of which the coefficient of correlation is greater than or equal to the threshold value. According to an example embodiment, the coefficient of correlation may be calculated by using schemes of calculating various coefficients of correlation such as a Pearson coefficient of correlation, a Spearman's rank correlation coefficient, or a Kendall's tau coefficient, but is not limited to the above-description. The threshold value may be set as a boundary value that may be determined as having a relevant correlation based on a characteristic of each coefficient of correlation calculation scheme. The above-described causality graph may be generated and input with the selected portion of the whole factors associated with the battery manufacturing process, which is selected, as a reference.

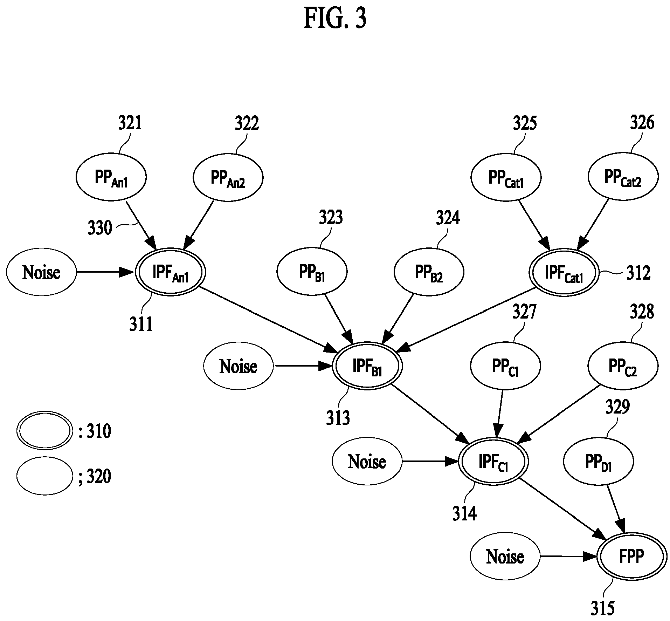

FIG. 3 will be referenced in order to see an example of the causality graph described above.

FIG. 3 is an example diagram illustrating a causality graph according to an example embodiment.

Referring to FIG. 3, an example of the causality graph may be shown. In FIG. 3, $IPF_{An1}$ 311 that is one of materiality nodes 310 may be a node corresponding to an intermediate product feature based on an process. $PP_{An1}$ 321 and $PP_{An2}$ 322 may be nodes corresponding to process parameters that may be controlled in association with the An1 process. For example, the An1 process is a rolling process, the $PP_{An1}$ 321 may be a node correspond to rolling pressure, and the $PP_{An2}$ 322 may be a node corresponding to rolling speed. As such, the causality graph in which a one-way edge is connected from a process parameter node 320 corresponding to a process parameter that may be controlled in a corresponding detailed process to a materiality node 310 corresponding to an intermediate product feature in each detailed process may be identified. In addition, as identifiable in FIG. 3, a one-way edge connected from noise to a node associated with each intermediate product feature may be present in order to reflect a measurement error or other various errors. Meanwhile, an FPP node 315 may be a node corresponding to a final product property, and nodes 311, 312, 313, and 314 marked with IPF each may be a node corresponding to the intermediate product feature. The above-described causality graph of FIG. 3 may be merely an example, and a large portion thereof may be simplified for convenience for description. For example, several FPPs may be present, and each process parameters may be connected to various intermediate products, or relationships between IPFs may be connected in a more complicated structure. In FIG. 3, an edge 330 connected from the $PP_{An1}$ 321 to the $IPF_{An1}$ 311 is marked for content that will be described below.

The electronic device 100 may identify information on process data in parallel with a process of identifying the above-described causality graph. The process data may include data on a plurality of factors, which is identified for each time of performing the battery manufacturing process, as an individual data instance. Here, the individual data instance may be data on a factor associated with a process of manufacturing an individual cell. For example, a predetermined data instance associated with a predetermined cell may include information on a process parameter for each detailed process, which is set in a manufacturing process for the predetermined cell, and an intermediate product feature. The process data may include such a data instance for each time of performing the battery manufacturing process.

Also, when the above-described causality graph is generated with a portion, which is selected from whole factors associated with the battery manufacturing process, as a reference, the process data may include data corresponding to the selected portion of factors. For example, when a portion of the whole factors of the battery manufacturing process is filtered based on a coefficient of correlation, the process data may include, for each data instance, data on a factor not filtered. Accordingly, the electronic device 100 may identify at least a portion of data, which corresponds to a plurality of selected factors in whole process data, as the process data.

According to an example embodiment, a factor may be filtered based on the coefficient of correlation as described above, and then some data instances may be filtered based on a measured temperature of the final product property. That is, the electronic device 100 may identify a data instance, in which the measured temperature of the final product property corresponds to a valid temperature range among data instances included in the whole process data, as the process data. Since a temperature has a large impact on measurement of the final product property, such a valid temperature range may be set in order to analyze a performance affecting factor with final product properties, which are measured at similar temperatures within the valid temperature range, as a reference. The valid temperature range may be set to a range within which the final product property is measured not differently due to a temperature and may be set to a predetermined temperature range, for example, from 28.5 to 29.5 degrees Celsius. Here, the individual data instance included in the process data may not include data on the final product property which is based on performance of a corresponding manufacturing process, and the model 110 may be in a state of having been trained with a data instance as an input and with data, on the final product property which corresponds to the data instance and is actually measured, as an answer.

Hereinafter, an example embodiment in which the electronic device 100 identifies information on an impact on battery performance for each of the plurality of factors by using the model 110 together with the above-described causality graph and process data will be described.

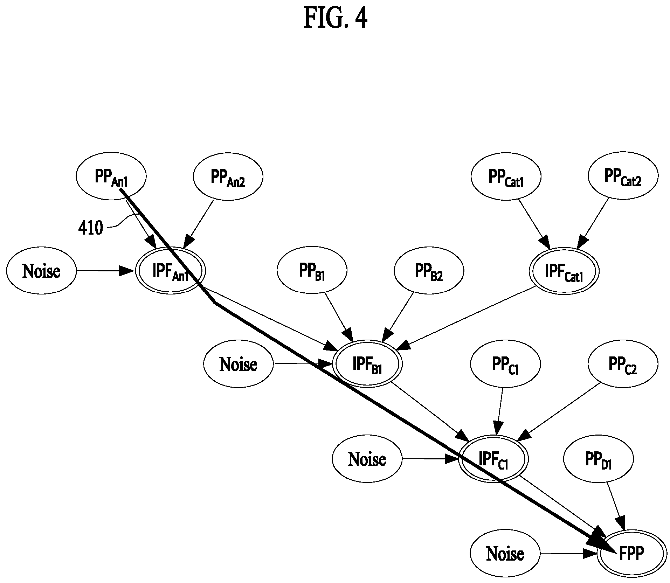

According to an example embodiment, the electronic device 100 may identify, based on the causality graph, a plurality of paths connected from a plurality of process parameter nodes to a materiality node corresponding to the final product property. For example, the electronic device 100 may identify all paths allowed in the causality graph. According to an example embodiment, as such the electronic device 100 may identify the plurality of paths connected from the plurality of process parameter nodes to the materiality node corresponding to the final product property through depth first search (DFS). An example in which the paths are identified as such with respect to the above-described example of FIG. 3 will be identified with reference to FIG. 4.

Referring to FIG. 4, an example 410 of a first path connected from a $PP_{An1}$ node 321 that is one of the process parameter nodes 320 described above with reference to FIG. 3 to the FPP node 315 which corresponds to the final product property may be identified. Although not illustrated in FIG. 4 for convenience for description, similarly to a first path 410, a plurality of paths may include a path continuing from each of the process parameter nodes 320, namely, $PP_{An2}, PP_{B1}, PP_{B2}, PP_{Cat1}, PP_{Cat2}, PP_{C1}, PP_{C2}, PP_{D1}$ represented by reference numerals 322 to 329 of FIG. 3 to the FPP node 315. For convenience for description, in the following paragraphs, paths continuing from the $PP_{An2}, PP_{B1}, PP_{B2}, PP_{Cat1}, PP_{Cat2}, PP_{C1}, PP_{C2}, PP_{D1}$ represented by reference numerals 322 to 329 to the FPP node 315 may be individually described as second to ninth paths.

Afterward, the electronic device 100 may identify a virtual data instance by adjusting at least a portion of data of a data instance included in process data based on the plurality of paths identified as such. In the virtual data instance, data corresponding to some factors in the data of the data instance may be used without any change, but a value corresponding to another factor may be data randomly sampled in a batch (which is the process data in the present disclosure) and identified. The electronic device 100 may identify the virtual data instance identified as such to the model 110 and accordingly identify information on an impact by analyzing an output of the model 110 on the virtual data instance. Hereinafter, such a process will be described in further detail.

According to an example embodiment, the electronic device 100 may identify an impact value for each edge in the causality graph. Here, since an edge is formed in a one-way direction, an impact value of the edge may be a value of an impact, of a factor corresponding to a parent node, on a factor corresponding to a child node. For example, the electronic device 100 may calculate a value of an impact, of configuration of a process parameter corresponding to the $PP_{An1}$ node 321, on an intermediate product property corresponding to a $IPF_{An1}$ node 311.

In order to calculate the impact value of the edge as such, the electronic device 100 may identify at least one first path including an edge between a first node corresponding to a first factor and a second node corresponding to a child node of the first node in the causality graph. For example, the above-described edge 330 of FIG. 3 may be included in the first path 410 of FIG. 4. There is one single path including the edge in the present example, but in another case, for example, several paths including an edge between IPFs may be present.

The electronic device 100 may identify at least one first virtual data instance based on the first path. Here, a process of identifying the first virtual data instance according to an example embodiment will be described.

According to an example embodiment, the electronic device 100 may identify a plurality of permutations in which the plurality of paths is randomly arranged. For example, in the above-described example of FIG. 4, the electronic device 100 may identify 9! = 362880 permutations in which first to ninth paths are randomly arranged. Such permutations all may be identified, but an example embodiment of sampling and identifying a portion thereof is also allowed. The electronic device 100 may identify, for each permutation, at least one path positioned before the above-described first path. For example, when a permutation is formed to be "second path, third path, first path, fourth, etc.", the electronic device 100 may identify, for the permutation, the second path and the third path as the at least one path positioned before the first path. The electronic device 100 may identify, for each of the plurality of permutations, a first subset including the at least one path positioned before the above-described first path and a second subset including the first path in addition to the first subset. For example, in the above-described example, the first subset may be formed to be "second path, third path", and the second subset may be formed to be "second path, third path, first path".

Then, the electronic device 100 may identify a first-first virtual data instance by sampling randomly and adjusting data on a node not corresponding to the first subset in the data of the data instance and identify a first-second virtual data instance by sampling randomly and adjusting data on a node not corresponding to the second subset in the data of the data instance. For example, when the above-described example is described in combination with a path example of FIG. 4, for the first subset which is formed to be "second path, third path", the electronic device 100 may maintain, for each data instance, values of nodes included in the path of the first subset and identify the first-first virtual data instance by randomly sampling values of $PP_{An2}, PP_{B1}, PP_{B2}, PP_{Cat1}, PP_{Cat2}, PP_{C1}, PP_{C2}, PP_{D1}$ represented by reference numerals 321, 324, 325, 326, 327, 328, 329, and 312, which are nodes not included in the path of the first subset, from another data instance included in the process data. For example, such a random sampling task may be performed for all data instances, so that the first-first virtual data instance may be identified, or the random sampling task may be performed exclusively for a portion of the data instances, so that the first-first virtual data instance may be identified. Similarly, for the second subset, values corresponding to nodes included in paths of the second subset may be maintained for each data instance, and the first-second virtual data instance may be identified by randomly sampling values of represented by reference numerals 324, 325, 326, 327, 328, 329, and 312, which are nodes not included in the paths of the second subset, from another data instance included in the process data. Also for the first-second virtual data instance, such a random sampling task may be performed for all the data instances, so that the first-second virtual data instance may be identified, or the random sampling task may be performed exclusively for a portion of the data instances, so that the first-second virtual data instance may be identified.

According to an example embodiment, the electronic device 100 may identify first-first value information and first-second value information based on a result of inputting, to the model 110, the first-first virtual data instance and the first-second virtual data instance. Specifically, the electronic device 100 may identify first-first output information by inputting first-first data instance to the model 110. Afterward, the electronic device 100 may identify information on a difference between information on an average of pieces of output information identified by inputting unadjusted original data instances included in the process data to the model 110 and the first-first output information and may use the information on the difference as the first-first value information. The information on the average of the pieces of output information identified by inputting the unadjusted original data instances to the model 110 may be calculated in advance. Also, similarly, the electronic device 100 may identify first-second output information by inputting first-second data instance to the model 110. Afterward, the electronic device 100 may identify information on a difference between the information on the average of the pieces of output information identified by inputting the unadjusted original data instances included in the process data and the first-second output information and may use the information on the difference as the first-second value information.

According to an example embodiment, the electronic device 100 may calculate information on a difference between the first-first value information and the first-second value information. Since the above-described first subset, second subset, first-first virtual data instance, and first-second virtual data instance are identified for each permutation, the first-first value information and the first-second value information may be identified for each permutation. The electronic device 100 may calculate the information on the difference between the first-first value information and the first-second value information which are identified for each permutation. Then, the electronic device 100 may calculate information on an average of pieces of information on the difference between the first-first value information and the first-second value information and may identify the information on the average of the pieces of information on the difference as first value information on the first path. That is, referring back to the above-described example, the electronic device 100 may calculate the information on the difference between the first-first value information on the first subset which is formed to be "second path, third path" and the first-second value information on the second subset which is formed to be "second path, third path, first path". Accordingly, the information on the difference between the first-first value information and the first-second value information, on corresponding permutations, may be calculated. When the information on the difference between the first-first value information and the first-second value information on the respective permutations is calculated in a similar way, such an average of the pieces of the information on the difference may be identified as the first value information on the first path. The above-described scheme may be a scheme, which is suitable for identifying a degree to which values included in the first path contribute when the model 110 receives the data instance and outputs the final product property, and will be described below.

According to an example embodiment, the electronic device 100 may identify a first impact value of the first factor on a second factor based on information on a sum of pieces of the first value information on the first path which includes the edge between the first node and the second node. Since the edge 330 in the above-described example of FIG. 3 is included in the first path 410 of FIG. 4, namely, one sole path, the first value information on the first path 410 may be identified as the first impact value of the first factor on the second factor without any change. However, in contrast, since an edge $IPF_{C1}$ connecting and FPP may be included in all the first to ninth paths, a sum of pieces of value information on the first to ninth paths may be calculated as an impact value of the edge, namely, an impact value of an intermediate product $IPF_{C1}$ on the FPP. As another example, an edge connecting $IPF_{Cat1}$ and $IPF_{B1}$ may be included in fifth and sixth paths, a sum of pieces of value information on the fifth and sixth paths may be calculated as an impact value of the edge, namely, an impact value of an intermediate product $IPF_{Cat1}$ on an intermediate product $IPF_{B1}$.

Hereinafter, the above-described series of impact value calculation processes will be described through Equations 1 to 3. To begin with, Equation 1 associated with a function that calculates value information will be described.

[Equation 1]

$$\tilde{\phi}_v(a) = \sum_{\pi \in \Pi_{dfs}} \frac{\tilde{v}([b: \pi(b) \leq \pi(a)]) - \tilde{v}([b: \pi(b) < \pi(a)])}{|\Pi_{dfs}|}$$

In Equation 1, $\Pi_{dfs}$ may denote a set including the above-described plurality of permutations. % may denote one permutation included in the $\Pi_{dfs}$. In addition, a may denote the first path. $\pi(x)$ may denote a place of a path $x$ in a permutation $\pi$. With such definitions, it may be understood that $[b:\pi(b) \leq \pi(a)]$ may denote the above-described second subset as a subset including a path, which has a place before or equal to that of the first path in a corresponding permutation, as an element and that $[b:\pi(b) < \pi(a)]$ may denote the above-described first subset as a subset including a path, which has a place before that of the first path in the corresponding permutation, as an element. Also, $\tilde{v}$ may denote a function, as the function that calculates the value information, which receives a subset including at least one path as an input, maintains a value corresponding to a node included in a corresponding path in the data instance without any change, and outputs information on a difference between an average of pieces of output information obtained by randomly sampling values of factors corresponding to a node not included in the path from other data instances of the process data and inputting the values to the model 110 and an average of pieces of output information obtained by inputting whole data instances of the process data as describe above. $\tilde{v}$ is a function of which a purpose is identical to that of $v$ of Equation 2, but has a relatively different input value as described below.

[Equation 2]

$$v(S) = \int \hat{f}(x_1, \dots, x_p) d\mathbb{P}_{x \notin S} - \mathbb{E}_X\left(\hat{f}(X)\right)$$

In Equation 2, $S$ may denote a set (or coalition) including at least one node. $x_1, \dots, x_p$ may denote values individually corresponding to $p$ whole factors. $\int \hat{f}(x_1, \dots, x_p) d\mathbb{P}_{x \notin S}$ may denote calculating, for an allowed combination of parameters not included in a set $S$, an integral of $\hat{f}$, namely, a function corresponding to the model 110 and may be understood as being equal to an average of results of inputting, to the model 110, data instances obtained by randomly sampling the parameters not included in the set $S$. $\mathbb{E}_X\left(\hat{f}(X)\right)$ may denote an average of pieces of output information of the model 110 on a process data whole set H. As identifiable in the above description of Equation 2, although there is a difference because the receives a subset including a node as an input and the $\tilde{v}$ receives the subset including the path as the input, those skilled in the art may understand, from Equation 2, the $\tilde{v}$ which receives the subset including the path the input.

[Equation 3]

$$\tilde{\phi}_v(e) = \sum_{p \in paths\ in\ \mathcal{G}} \mathbf{1}_{p\ contains}(e)\tilde{\phi}_v(p)$$

In Equation 3, *paths in* $\mathcal{G}$ may denote the above-described permutation of a causality graph $\mathcal{G}$. $\mathbf{1}_{p\ contains}(e)$ may have a value of 1 exclusively when a path J includes an edge L and have a value of 0 otherwise. $\tilde{\phi}_v(p)$ may denote value information on the path J. According to such Equation 3, $\tilde{\phi}_v(e)$ may have, as an output value, information on a sum of pieces of value information on all paths $p$ including the edge $e$. This may be identical to the above-described definition of an impact value of the edge $e$.

An impact value calculation scheme based on the above-described equations may be an application of a scheme of calculating a Shapley value. The Shapley value is a value that originates from game theory and is used to evaluate a contribution degree of each participant. That is, an impact value of each edge may be understood as a value as which a contribution degree of each edge is evaluated in a sense similar to the Shapley value.

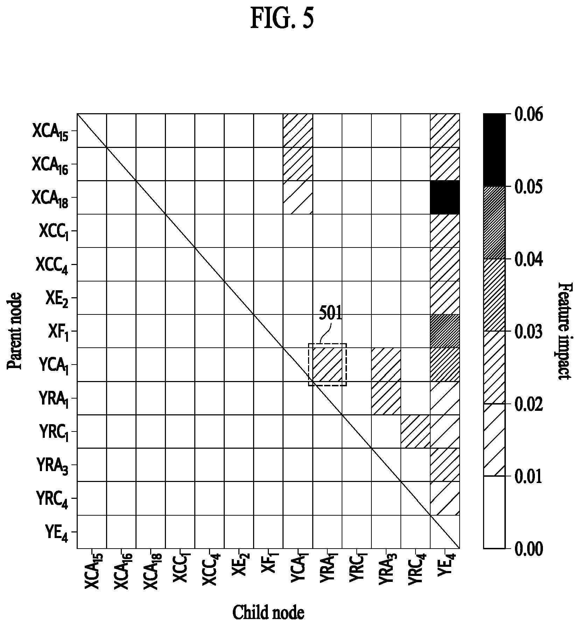

According to the above-described example embodiment, when the impact value of the factor corresponding to the parent node on the factor corresponding to the child node, with the parent node and the child node connected through an edge, is calculated for each edge, the electronic device 100 may identify a matrix including the impact value. For example, the electronic device 100 may identify a matrix that includes an impact value, of the first factor which corresponds to a first coordinate on a first axis, on the second factor which corresponds to a second coordinate on a second axis, as an element. Since the impact value, of the first factor corresponding to the first coordinate on the first axis, on the second factor corresponding to the second coordinate on the second axis is included as the element, the matrix may have a form of a triangular matrix. A diagonal element and an element showing an impact value between nodes not directly connected to each other may be automatically input as 0. FIG. 5 will be referenced in order to describe such an example.

FIG. 5 is a diagram illustrating an example of a matrix including an impact value according to an example embodiment.

Referring to FIG. 5, the matrix may include a vertical axis corresponding to a parent node and a horizontal axis corresponding to a child node. Each element may be an impact value, of a factor corresponding to a coordinate on the vertical axis, on a factor corresponding to a coordinate on the horizontal axis. For example, an example element 501 may be an impact value of a factor $YCA_1$ on a factor $YRA_1$. In an example of FIG. 5, a first axis and a second axis may correspond to the vertical axis and the horizontal axis, respectively.

According to an example embodiment, the electronic device 100 may identify, based on the above-described matrix, information on an impact including information on a direct impact and information on an indirect impact, of a plurality of factors, on a final product property.

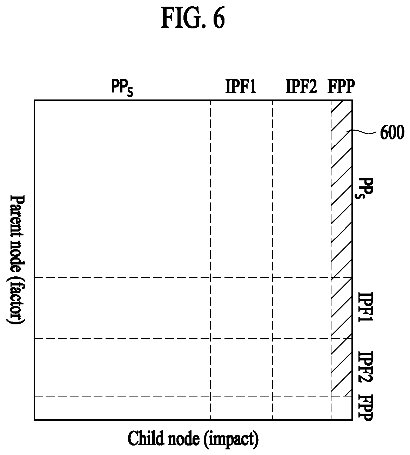

To begin with, with respect to the information on the direct impact, the electronic device 100 may identify an impact value of at least one factor corresponding to at least one node directly connected to a node corresponding to the final product property in the matrix. For example, according to the above-described example of FIG. 3, the electronic device 100 may identify impact values of $IPF_{C1}$, $PP_{D1}$, and $PP_{D2}$ on FPP. The electronic device 100 may identify the information on the direct impact based on at least one impact value identified as such. The impact value of the at least one factor corresponding to the above-described at least one directly connected node may be easily identified through the matrix. In other words, the electronic device 100 may identify a coordinate corresponding to the final product property on the second axis which corresponds to the child node, identify a vector in the matrix, which has the coordinate corresponding to the final product property on the second axis and is parallel to the first axis, and identify, based on the vector, the impact value of the at least one factor corresponding to the above-described at least one directly connected node. Further specifically, elements included in the identified vector in the matrix may be identified as impact values of the at least one factor corresponding to the above-described at least one directly connected node. FIG. 6 will be referenced in order to see an example of the vector.

FIG. 6 is a diagram illustrating an example of identifying information on a direct impact by using a matrix according to an example embodiment.

Referring to FIG. 6, the electronic device 100 may identify that a coordinate corresponding to an FPP on a second axis is a coordinate at a right end and identify a vector 600 having the coordinate and parallel to a first axis. The electronic device 100 may identify values included in the vector 600 as impact values of at least one factor corresponding to at least one directly connected node.

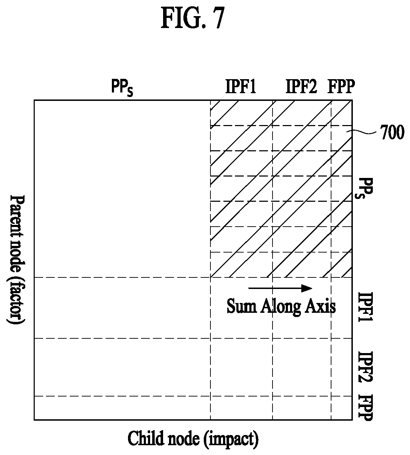

Then, with respect to information on an indirect impact, the electronic device 100 may identify, by factor corresponding to each process parameter nodes, information on a sum of impact values. Furthermore, the information on the indirect impact may be identified, by factor corresponding to each process parameter node, based on the information on the sum. For example, according to the above-described example of FIG. 3, the electronic device 100 may identify, for respective factors of $PP_{An1}$, $PP_{An2}$, $PP_{B1}$, $PP_{B2}$, $PP_{Cat1}$, $PP_{Cat2}$, $PP_{C1}$, $PP_{C2}$, $PP_{D1}$, information on a sum of impact values. The electronic device 100 may identify the information on the indirect impact based on at least one impact value identified for each factor as such. An impact value by factor corresponding to each process parameter node described above may be easily identified through the matrix. For example, the electronic device 100 may identify a coordinate corresponding to each process parameter on the first axis in the matrix. The electronic device 100 may identifying each vector in the matrix, which has the coordinate corresponding to each process parameter on the first axis and is parallel to the second axis. The electronic device 100 may identify, by factor corresponding to each process parameter node, information on a sum of impact values included in each vector and identify the information on the indirect impact based on the information on the sum. FIG. 7 will be referenced in order to see an example of such a vector.

FIG. 7 is a diagram illustrating an example of identifying information on an indirect impact by using a matrix according to an example embodiment.

Referring to FIG. 7, the electronic device 100 may identify coordinates individually corresponding to process parameter nodes, namely, PPs on a first axis and identify vectors 700 having the coordinates and parallel to a second axis. The electronic device 100 may identify information on an indirect impact for each process parameter by obtaining a sum of values included in the vectors 700 by vector. FIG. 7 illustrates that the vectors 700 parallel to the second axis correspond to respective portions of rows having the coordinates, not to the entire rows. This is because since the PPs, namely, the process parameters are set to 0 as not affecting each other, results will be identical no matter portions associated with impact values between the PPs are included or not included.

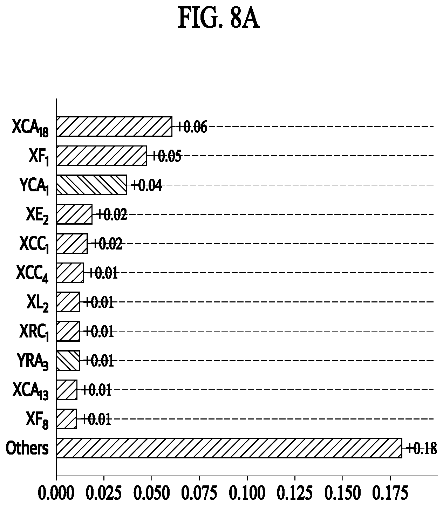

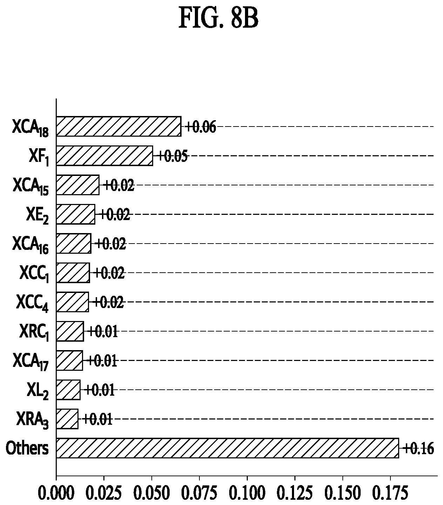

According to an example embodiment, the electronic device 100 may identify and graph information on a direct impact and the information on the indirect impact according to the above-described example embodiment. FIGS. 8A and 8B will be referenced in order to see an example of the information on the direct impact and the information on the indirect impact graphed as such.

FIGS. 8A and 8B are graphs showing information on a direct impact and information on an indirect impact according to an example embodiment.

FIG. 8A is a graph showing the information on the direct impact. A vertical axis thereof may show each factor. A direct impact value of each factor on a final product property may be identified through a bar parallel to a horizontal axis thereof. Factors with a prefix of X among factors on the vertical axis, for example, $XCA_{18}$, $XF_1$, and the like may be process parameters. Factors with a prefix of Y, for example, $YCA_1$, $YRA_3$, and the like may be intermediate product features.

FIG. 8B is a graph showing the information on the indirect impact. A vertical axis thereof may show each factor. An indirect impact value of each process parameter may be identified through a bar parallel to a horizontal axis thereof. Since the graph shows the information on the indirect impact, it may be identified that an intermediate product feature with the prefix of Y is absent unlike the FIG. 8A.

When FIGS. 8A and 8B are compared, it may be identified that $XCA_{15}$ is absent in the information on the direct impact, but the $XCA_{15}$ is present and ranked third in the information on the indirect impact. This may mean that the $XCA_{15}$ has a relatively smaller direct impact as not being a process parameter mainly acting in a process of generating a final product from a nearly finalized intermediate product, but has a large impact on previous intermediate products. Similarly, a factor not included in the information on the direct impact but having a not small portion in the information on the indirect impact may include $XCA_{16}$ and $XCA_{17}$. As such, the information on the direct impact and the information on the indirect impact may be differently used in that each shows information on a relatively different factor.

According to an example embodiment, the electronic device 100 may support control of the intermediate product feature based on the information on the direct impact. Specifically, the information on the direct impact may be beneficially used by a product designer desiring to analyze and adjust intermediate products and efficiently design a cell. Accordingly, the electronic device 100 may support products designers by providing the information on the direct impact to a product designer terminal so that the product designers may adjust the intermediate products and perform cell designing.

According to an example embodiment, the electronic device 100 may support control of the process parameters for each detailed process based on the information on the indirect impact. Specifically, the information on the indirect impact may be beneficially used by process operators desiring to efficiently set a process parameter associated with each detailed process and control quality. Accordingly, the electronic device 100 may support the process operators by providing the information on the indirect impact to a process operator terminal so that the process operators may efficiently control the process parameter and secure high cell quality.

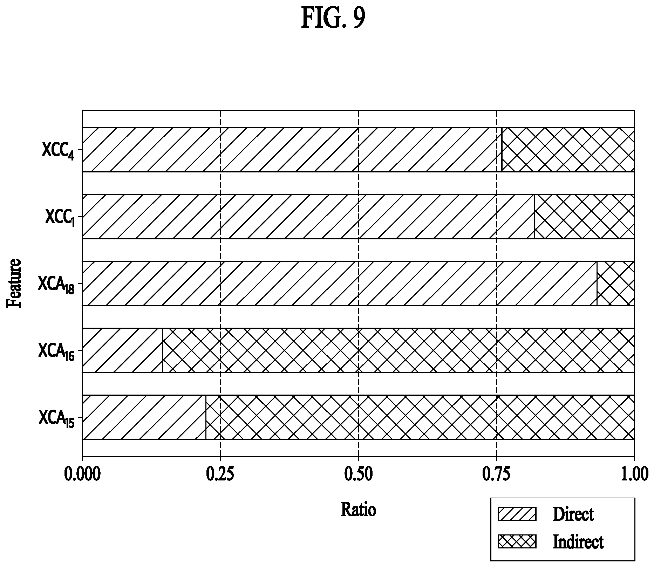

According to an example embodiment, the electronic device 100 may identify additional analysis information. Specifically, the electronic device 100 may identify, based on information on an impact, contribution ratio information showing ratios of values of the information on the direct impact and the information on the indirect impact for each of a plurality of factors. In other words, the electronic device 100 may calculate, by obtaining a sum of values shown for each factor by the information on the direct impact and the information on the indirect impact and then dividing the values by the sum, ratios of the direct impact and the indirect impact in an impact of each factor on an overall battery manufacturing process and may accordingly identify the contribution ratio information. FIG. 9 will be referenced in order to see an example of the contribution ratio information.

FIG. 9 is an example diagram illustrating contribution ratio information according to an example embodiment.

Referring to FIG. 9, it may be identified that a ratio of information on a direct impact of a process parameter $XCA_{18}$ is greatly higher and that ratios of pieces of information on indirect impacts of process parameters $XCA_{16}$ and $XCA_{15}$ are greatly higher. Based on such contribution ratio information, managers may identify that an intermediate product feature that properly reflects an impact of $XCA_{18}$ is absent and that on the contrary, $XCA_{16}$ and $XCA_{15}$ may greatly affect an intermediate product feature connected thereto. Also, as an additional example, the managers may that in a case in which nodes corresponding to the $XCA_{16}$ and the $XCA_{15}$ are connected to a node corresponding to an identical intermediate product feature, the corresponding intermediate product feature may be controlled by adjusting the $XCA_{16}$ and the $XCA_{15}$.

The model 110 which is used to perform the above-described battery performance affecting factor analysis method may be a model trained by the electronic device 100 or may be a pre-trained model that is input to the electronic device 100. Hereinafter, an example in which the model 110 is trained by the electronic device 100 will be described.

According to an example embodiment, the electronic device 100 may input the above-described process data to the model 110 in units of a data instance. The electronic device 100 may identify a result of comparison between actual data corresponding to a final product property identified in units of the data instance and an output of the model 110. Afterward, the electronic device 100 may train the artificial intelligence model 110 based on the result. For example, when the model 110 is constructed by using a DNN, the electronic device 100 may train the model 110 by calculating a loss function based on the result of comparison and back-propagating a loss.

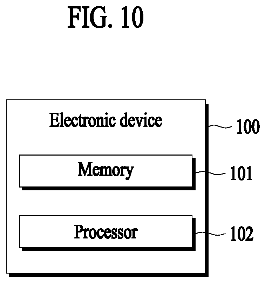

FIG. 10 is a block diagram illustrating an electronic device according to an example embodiment.

According to an example embodiment, the electronic device 100 may include a memory 101 and a processor 102. Elements exclusively associated with the present example embodiment are illustrated with respect to the electronic device 100 illustrated in FIG. 1. Thus, those skilled in the art associated with the present example embodiment may understand that other elements in general use in addition to the elements illustrated in FIG. 10 may be further included. In an example embodiment, the processor 102 may be included in a controller.

The processor 102 may control overall operations of the electronic device 100 and process data and a signal. The processor 102 may be formed with at least one hardware unit. In addition, the processor 102 may be operated by one or more software modules generated by executing program code stored in the memory 101. Since the processor 102 may include a memory, the processor 102 may control the overall operations of the electronic device 100 and process the data and the signal by executing program code stored in the memory.

The process 102 may be configured to, by executing one or more instructions, identify a causality graph showing a relationship between a plurality of factors associated with a battery manufacturing process and process data that includes data on the plurality of factors, which is identified for each time of performing the battery manufacturing process, as an individual data instance and identify information on an impact on a final product property for each of the plurality of factors based on the causality graph, the process data, and a model trained to predict the final product property in the battery manufacturing process by receiving the process data as an input.

In some example embodiments, the electronic device 100 may additionally include a transceiver for performing wired/wireless communication. The electronic device 100 may communicate with an external electronic device by using the transceiver. The external electronic device may be a terminal or a server. Also, a communication technology used by the transceiver may include Global System for Mobile communication (GSM), Code Division Multi Access (CDMA), Long Term Evolution (LTE), 5th Generation, (5G), a wireless local area network (WLAN), Wireless-Fidelity (Wi-Fi), Bluetooth, radio frequency identification (RFID), infrared data association (IrDA), ZigBee, near field communication (NFC), or the like.

The electronic apparatus according to the above-described example embodiments may include a processor, a memory that stores and executes program data, a permanent storage such as a disk drive, a communication port for communicating with an external device, and a user interface device such as a touch panel, a key, and a button. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor.

The above-described embodiments are merely examples and other embodiments may be implemented within the scope of the following claims.

**Claims**

1. A battery performance affecting factor analysis method of an electronic device, the battery performance affecting factor analysis method comprising:

   identifying a causality graph showing a relationship between a plurality of factors associated with a battery manufacturing process and process data that includes data on the plurality of factors, which is identified for each time of performing the battery manufacturing process, as an individual data instance; and
   identifying information on an impact on a final product property for each of the plurality of factors based on the causality graph, the process data, and a model trained to predict the final product property in the battery manufacturing process by receiving the process data as an input,
   wherein the causality graph shows:

      materiality nodes that are connected in a one-way direction corresponding to an order of detailed processes included in the battery manufacturing process and individually correspond to an intermediate product feature and the final product property which are generated individually in the detailed processes; and
      a plurality of process parameter nodes that is connected to each of the materiality nodes in one-way directions and corresponds to process parameters controlled in each of the detailed processes which individually correspond to the materiality nodes.

2. The battery performance affecting factor analysis method of claim 1, further comprising:

   identifying, based on the causality graph, a plurality of paths connected from the plurality of process parameter nodes to a materiality node corresponding to the final product property;
   identifying a virtual data instance by adjusting at least a portion of data of the data instance included in the process data based on the plurality of identified paths;
   inputting the virtual data instance to the model; and
   identifying the information on the impact by analyzing an output, of the model, on the virtual data instance.

3. The battery performance affecting factor analysis method of claim 2, wherein the identifying of the virtual data instance comprises:

   identifying, based on the plurality of paths, at least one first path including an edge between a first node corresponding to a first factor and a second node corresponding to a child node of the first node in the causality graph; and
   identifying at least one first virtual data instance based on the at least one first path, and
   the identifying of the information on the impact comprises:

      identifying first value information on the first path based on the first virtual data instance and the model; and
      identifying an impact value of the first factor on a second factor corresponding to the second node based on the first value information.

4. The battery performance affecting factor analysis method of claim 3, wherein the identifying of the at least one first virtual data instance comprises:

   identifying at least one path positioned before the at least one first path in a plurality of permutations in which the plurality of paths is randomly arranged;
   identifying, for each of the plurality of permutations, a first subset including the at least one path positioned before the at least one first path and a second subset including the first path in addition to the first subset; and
   identifying a first-first virtual data instance by sampling randomly and adjusting data on a node not corresponding to the first subset in the data of the data instance and identifying a first-second virtual data instance by sampling randomly and adjusting data on a node not corresponding to the second subset in the data of the data instance, and
   the identifying of the first value information comprises:

      identifying first-first value information and first-second value information based on a result of inputting, to the model, the first-first virtual data instance and the first-second virtual data instance which are identified for each of the plurality of permutations; and

identifying the first value information based on information on a difference between the first-first value information and the first-second value information.

5. The battery performance affecting factor analysis method of claim 4, wherein the identifying of the first value information comprises identifying the first value information on the first path based on information on an average of pieces of information on the difference between the first-first value information and the first-second value information identified for each of the plurality of mutations.

6. The battery performance affecting factor analysis method of claim 4, wherein the identifying of the first value information comprises:

identifying first-first output information by inputting the first-first virtual data instance to the model; and
identifying the first-first value information based on information on a difference between the first-first output information and information on an average of pieces of output information identified by inputting the data instance is not adjusted.

7. The battery performance affecting factor analysis method of claim 3, wherein the identifying of the information on the impact of the first factor comprises identifying a first impact value of the first factor on the second factor based on information on a sum of pieces of the first value information on the first path which includes the edge between the first node and the second node.

8. The battery performance affecting factor analysis method of claim 1, wherein the identifying of the information on the effect comprises:
identifying a matrix that includes an impact value, of a first factor corresponding to a first coordinate on a first axis, on a second factor corresponding to a second coordinate on a second axis, as an element; and identifying, based on the matrix, the information on the impact which includes information on a direct impact and information on an indirect impact, of the plurality of factors, on the final product property.

9. The battery performance affecting factor analysis method of claim 8, wherein the identifying of the information on the impact comprises:

identifying an impact value of at least one factor corresponding to at least one node directly connected to a node corresponding to the final product property in the matrix; and
identifying the information on the direct impact based on the impact value of the at least one factor.

10. The battery performance affecting factor analysis method of claim 9, wherein the identifying of the impact value of the at least one factor comprises:

identifying a coordinate corresponding to the final product property on the second axis;
identifying a vector in the matrix, which has the coordinate corresponding to the final product property on the second axis and is parallel to the first axis; and
identifying the impact value of the at least one factor based on the vector.

11. The battery performance affecting factor analysis method of claim 8, wherein the identifying of the information on the effect comprises:

identifying, by factor corresponding to each of the process parameter nodes, information on a sum of impact values; and
identifying, by factor corresponding to each of the process parameter nodes, the information on the indirect impact based on the information on the sum.

12. The battery performance affecting factor analysis method of claim 11, wherein the identifying of the information on the sum comprises:

identifying a coordinate corresponding to each of the process parameters on the first axis;
identifying each of vectors in the matrix, which has the coordinate corresponding to each of the process parameters on the first axis and is parallel to the second axis; and
identifying, by factor corresponding to each of the process parameter nodes, information on a sum of impact values included in each of the vectors.

13. The battery performance affecting factor analysis method of claim 8, further comprising identifying, based on the information on the impact, contribution ratio information showing ratios of values of the information on the direct impact and the information on the indirect impact for each of the plurality of factors.

14. The battery performance affecting factor analysis method of claim 8, further comprising supporting control of the intermediate product feature based on the information on the direct impact.

15. The battery performance affecting factor analysis method of claim 8, further comprising supporting control of the process parameters for each of the detailed processes based on the information on the indirect impact.

16. The battery performance affecting factor analysis method of claim 1, wherein the identifying of the causality graph and the process data comprises:

identifying whole process data identified for each time of performing the battery manufacturing process;
calculating a coefficient of correlation between whole factors of the battery manufacturing process based on the whole process data;
identifying the plurality of factors by filtering at least a portion of factors of which the coefficient of correlation is greater than or equal to a threshold value among the whole factors; and
identifying at least a portion of data, which corresponds to the plurality of factors in the whole process data, as the process data.

17. The battery performance affecting factor analysis method of claim 16, wherein the identifying of the at least a portion of data, which corresponds to the plurality of factors in the whole process data, as the process data comprises identifying a data instance, in which a measured temperature of the final product property corresponds to a valid temperature range among data instances included in the whole process data, as the process data.

18. The battery performance affecting factor analysis method of claim 1, further comprising:

inputting the process data to the model in units of the data instance; and
training the model based on a result of comparison between actual data corresponding to the final product property identified in units of the data instance and an output of the model.

19. A non-transitory computer-readable recording medium in which a program for executing the method of any one of claims 1 through 18 on a computer is recorded.

20. An electronic device for analyzing a battery performance affecting factor, the electronic device comprising:

a processor; and
a memory configured to store one or more instructions,
wherein the processors is configured to, by executing the one or more instructions:

identify a causality graph showing a relationship between a plurality of factors associated with a battery manufacturing process and process data that includes data on the plurality of factors, which is identified for each time of performing the battery manufacturing process, as an individual data instance; and
identify information on an impact on a final product property for each of the plurality of factors based on the causality graph, the process data, and a model trained to predict the final product property in the battery manufacturing process by receiving the process data as an input, and the causality graph shows:

materiality nodes that are connected in a one-way direction corresponding to an order of detailed processes included in the battery manufacturing process and individually correspond to an intermediate product feature and the final product property which are generated individually in the detailed processes; and
a plurality of process parameter nodes that is connected to each of the materiality nodes in one-way directions and corresponds to process parameters controlled in each of the detailed processes which individually correspond to the materiality nodes.

# FIG. 1

100

Electronic device

Causality graph →

Model — 110

Process data

EP 4 768 932 A1

## FIG. 2

```
                    ┌──────────────┐
                    │    Start     │
                    └──────────────┘
                            │
                            ▼
┌─────────────────────────────────────────────────────────┐
│  Identify causality graph showing relationship between   │      S210
│  plurality of factors associated with battery            │
│  manufacturing process and process data that includes    │
│  data on plurality of factors, which is identified for    │
│  each time of performing battery manufacturing process,  │
│  as individual data instance                             │
└─────────────────────────────────────────────────────────┘
                            │
                            ▼
┌─────────────────────────────────────────────────────────┐
│  Identify information on impact on final product          │      S220
│  property for each of plurality of factors based on      │
│  causality graph, process data, and model trained to     │
│  predict final product property in battery manufacturing │
│  process by receiving process data as input              │
└─────────────────────────────────────────────────────────┘
                            │
                            ▼
                    ┌──────────────┐
                    │     End      │
                    └──────────────┘
```

17

# FIG. 3

# FIG. 4

# FIG. 5

# FIG. 6

# FIG. 7

Parent node (factor)

Child node (impact)

# FIG. 8A

# FIG. 8B

# FIG. 9

FIG. 10

| Electronic device | ~ 100 |
| Memory | ~ 101 |
| Processor | ~ 102 |

## INTERNATIONAL SEARCH REPORT

| International application No. |
|---|
| **PCT/KR2025/006405** |

| A. | CLASSIFICATION OF SUBJECT MATTER |
|---|---|

**G01R 31/36**(2006.01)i; **G01R 31/367**(2019.01)i; **G01R 31/385**(2019.01)i; **G01R 31/396**(2019.01)i

According to International Patent Classification (IPC) or to both national classification and IPC

| B. | FIELDS SEARCHED |
|---|---|

Minimum documentation searched (classification system followed by classification symbols)

G01R 31/36(2006.01); G05B 19/418(2006.01); G06F 19/00(2011.01); H01M 10/42(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 제조 공정(manufacturing process), 성능(performance), 인과 그래프(causal graph), 노드(node), 에지(edge), 인스턴스(instance), 예측(prediction), 학습(learning), 파라미터(parameter), 경로(route), 샘플링(sampling), 좌표(coordinate), 행렬(matrix)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2024-0024694 A (LG ENERGY SOLUTION, LTD.) 26 February 2024 (2024-02-26) paragraph [0048]; and claim 8 | 1-2,18-20 |
| A | | 3-17 |
| Y | KR 10-2015-0018681 A (UNIST ACADEMY-INDUSTRY RESEARCH CORPORATION et al.) 24 February 2015 (2015-02-24) paragraphs [0048], [0078]; claim 1; and figure 4 | 1-2,18-20 |
| A | WANG, Jiaxuan et al. Shapley Flow: A Graph-based Approach to Interpreting Model Predictions. arXiv: 2010.14592v3 [cs.LG]. 26 February 2021. abstract; page 2; and figure 2(c) | 1-20 |
| A | WO 2024-077587 A1 (CONTEMPORARY AMPEREX TECHNOLOGY CO., LIMITED) 18 April 2024 (2024-04-18) abstract | 1-20 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 August 2025** | **08 August 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2025/006405** |

**C. DOCUMENTS CONSIDERED TO BE RELEVANT**

| Category* | Citation of document, with indication, where appropriate, of the relevant passages | Relevant to claim No. |
| --- | --- | --- |
| A | KIRCHHOF, Michael et al. Root Cause Analysis in Lithium-Ion Battery Production with FMEA-Based Large-Scale Bayesian Network. arXiv: 2006.03610v2 [stat.AP]. 15 June 2020.<br>abstract | 1-20 |

Form PCT/ISA/210 (second sheet) (July 2022)

**INTERNATIONAL SEARCH REPORT**
**Information on patent family members**

International application No.

**PCT/KR2025/006405**

| Patent document cited in search report | | | Publication date (day/month/year) | Patent family member(s) | | | Publication date (day/month/year) |
|---|---|---|---|---|---|---|---|
| KR | 10-2024-0024694 | A | 26 February 2024 | CN | 119604822 | A | 11 March 2025 |
| | | | | EP | 4575681 | A1 | 25 June 2025 |
| | | | | WO | 2024-039057 | A1 | 22 February 2024 |
| KR | 10-2015-0018681 | A | 24 February 2015 | KR | 10-1508641 | B1 | 08 April 2015 |
| WO | 2024-077587 | A1 | 18 April 2024 | CN | 118541846 | A | 23 August 2024 |

Form PCT/ISA/210 (patent family annex) (July 2022)